# EUROPEAN PATENT APPLICATION

(11) **EP 0 523 387 A2**
(43) Date of publication of application: **20.01.1993**
(21) Application number: 92110250.5
(22) Date of filing: 17.06.1992
(51) Int. Cl.: H01L 23/433, H01L 23/10

(54) **Semiconductor chip module and method for manufacturing the same**

(30) Priority: 18.06.1991 JP 146172/91; 12.07.1991 JP 172724/91; 12.07.1991 JP 172728/91; 12.07.1991 JP 172731/91
(71) Applicant: SUMITOMO ELECTRIC INDUSTRIES, LTD., Osaka-shi, Osaka 541 (JP)
(72) Inventor: Nishiguchi, Masanori, c/o Yohohama Works, Sakae-ku, Yokohama-shi, Kanagawa (JP)
(74) Representative: Lehn, Werner, Dipl.-Ing.

(57) **Abstract**

A semiconductor chip module comprises a substrate (1) on which a wiring portion (2) is formed, a semiconductor chip (6) mounted on the wiring portion (2) so as to face the circuit side thereof down to the wiring portion (2), a heat sink (3) having one end portion contacting the side opposite to the circuit surface of the semiconductor chip (6), and a cap (4) enclosing the semiconductor chip (6) and having an opening (4) for exposing externally the other end portion of the heat sink (3).

## Description

### Background of the Invention

### (Field of the Invention)

The present invention relates to a semiconductor chip module(multi-chip module and single chip module) and a method for manufacturing the same applicable for fields requiring high speed signal processing, for example, computers, communications, or the like.

### (Related Background Art)

With the increasing demands for large-scale function and high speed functions of electronic devices, logic LSIs have achieved high speed operation, for example, a delay time per gate of several hundreds picosecond. However, the conventional assembling structure which mounts a large number of dual-in packages (DIPs) or plug-in packages on a printed circuit board has become difficult to bring out the performance of high speed LSIs sufficiently. In order to overcome such a problem, a highly dense, multi-chip module system has been developed and put into practical use, which mounts many chips on a single ceramic substrate and can provide high speed performance and high density assembling (refer to "LSI Handbook", the first edition, pp. 415-416, The Institute of Electronics and Communication Engineers of Japan, 1984).

A prior art structure in which heat is dissipated to a cooling plate by contacting a piston on a semiconductor chip by means of a spring has been well-known (refer to "Materials/Processing Approaches to Phase Stabilization of Thermally Conductive Pastes" pp. 713-717, IEEE TRANSACTIONS OF COMPONENTS, HYBRIDS, AND MANUFACTURING TECHNOLOGY, Vol. 13, No. 4, December 1990.).

However, a semiconductor chip module employing a piston has a disadvantage of having a large number of components and the cost being extremely high.

### Summary of the Invention

An object of the present invention is to provide a semiconductor chip module which can perform excellent heat dissipation with a small number of components.

In order to achieve the above object, the present invention is constituted of a substrate on which a wiring portion is formed; a semiconductor chip mounted so as to face a circuit side down to the wiring portion; a heat sink with one end in contact with a side opposite to the circuit side of said semiconductor chip; and a cap which has an opening for exposing the other end of the heat sink, the cap enclosing the semiconductor chip.

According to the semiconductor chip module of the present invention, the heat which is generated from a specific semiconductor chip producing a relatively large amount of heat is conducted from the one end to the other end of the heat sink (lower temperature side), being in contact with the upper surface of the semiconductor chip. By this heat conduction, the heat is conducted to outside the cap, and dissipated.

In order to achieve the above object, the semiconductor chip module according to the present invention is constituted of a substrate on which a wiring portion is formed; a semiconductor chip mounted so as to face a circuit side thereof down to the wiring portion; a heat sink with one end in contact with a side opposite to the circuit side of the semiconductor chip; and a cap which has an opening for exposing the other end of said heat sink; and is characterized in that metal films are formed at least on the inner wall of the opening and a surface of the heat sink facing the inner wall; and an adhesive material (such as solder, etc.) is filled between the metal films.

Further, the semiconductor chip module according to the present invention comprises a substrate on which a wiring portion is formed; a semiconductor chip mounted so as to face the circuit side down to the wiring portion; a heat sink of which one end is contacted to the side opposite to the circuit side of the semiconductor chip; and a cap which has an opening for exposing the other end of the heat sink, the cap enclosing the semiconductor chip, the semiconductor chip module characterized in that the cap has a side wall for supporting the heat sink, the side wall having an injection opening communicating with the opening, and an adhesive material is filled between the side wall and the heat sink.

And a method of manufacturing the semiconductor chip module according to the above invention comprises the steps of preparing a substrate mounting a semiconductor chip, a cap which has a metal film formed previously on the inner wall of the opening, and a heat sink which has a metal film formed previously on one end thereof; fixing the cap on the substrate; inserting the one end of the heat sink into the opening of the cap to contact the one end of the heat sink to the semiconductor chip; and embedding an adhesive material between the metal films or injecting adhesive material into the injection hole of the side wall to fix the heat sink to the cap, while one end of the heat sink being contacted to the semiconductor chip, whereby the cap is hermetically sealed.

According to the semiconductor chip module of the present invention, the heat sink is fixed securely on the inner wall of the cap opening. The heat which is generated from a specific semiconductor chip producing a relatively large amount of heat is conducted from the one end to the other end of the heat sink(lower temperature side) being in contact with the upper surface of the semiconductor chip device. By this heat conduction, the heat is conducted toward a cap due to thermal conduction, and is dissipated outside the cap.

According to the method of manufacturing a semiconductor chip module of the present invention, when one end of the heat sink is inserted into the opening of the cap, it is pressed against the semiconductor chip, for example, by the weight of the heat sink itself. In this state, an adhesive material is inserted into the opening of the cap to fix the heat sink. The adhesive material is filled between the inner wall of the cap opening and the heat sink without any void therein to shut off air passage flowing in and out.

In order to achieve the above object, the semiconductor chip module according to the present invention is constituted of, a substrate on which a wiring portion is formed; a semiconductor chip mounted so as to face a circuit side thereof down to the wiring portion; a heat sink with one end in contact with a side opposite to the circuit side of said semiconductor chip; and a cap which has an opening for exposing the other end of said heat sink. The heat sink has a surface for being securely fixed on the cap using a adhesive material. The adhesive material is filled in the space between the cap and the surface of the heat sink, with the one end of the heat sink contacting the semiconductor chip.

In this case, a thermosetting adhesive material may be further placed in the gap between the cap and the surface of the heat sink.

The semiconductor chip module manufacturing method according to the present invention comprises the steps of preparing a substrate mounting the semiconductor chip, the cap, and the heat sink; fixing the cap on the substrate; inserting one end of the heat sink into an opening of the cap and then sandwiching a thermosetting adhesive material between the cap and the surface of the heat sink; and heating the thermosetting adhesive material to fix the heat sink to the cap, with the one end of the heat sink contacting the semiconductor chip, whereby the cap is sealed hermetically.

In the case where the thermosetting adhesive material is sandwiched further between the one end of the heat sink and the semiconductor chip, the cap is fixed to the heat sink by heating the heat sink, with the one end of the heat sink contacting the semiconductor chip, whereby the cap is sealed hermetically.

According to the semiconductor chip module of the present invention, the surface of a heat sink is fixed to the cap. The heat which is generated from a specific semiconductor chip producing a relatively large amount of heat is conducted from the one end of a heat sink being in contact with the upper surface of the semiconductor chip device to the other end (lower temperature side) thereof. By this heat conduction, the heat is conducted outside the cap, and is dissipated.

According to the method of manufacturing a semiconductor chip module of the present invention, an adhesive material is sandwiched between the surface of the heat sink and the cap by inserting one end of a heat sink into an opening of the cap; and contacting the one end of the heat sink to the semiconductor chip by its own weight due to the melting of the adhesive material, to fix the heat sink under such condition. The adhesive material is filled between the cap and the surface of the heat sink without any void therein to shut off passage of air flowing in and out.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art form this detailed description.

### Brief Description of the Drawings

Fig. 1 is a perspective view showing an external appearance of the semiconductor chip module according to the present invention,
Fig. 2 is a vertical cross sectional view obtained by taking along the heat sink the multi-chip module according to the present invention,
Figs. 3A and 3B are respectively a vertical cross sectional views showing a heat sink mounting structure applicable for the multi-chip module according to the present invention,
Figs. 4A, 4B and 4C are respectively a vertical cross sectional view showing another heat sink mounting example applicable for the multi-chip module according to the second embodiment of the present invention,
Figs. 5A, 5B are respectively a vertical cross sectional view showing a heat sink mounting structure example applicable for the multi-chip module according to the third embodiment of the present invention,
Fig. 6A and 6B are respectively a vertical cross sectional view showing a heat sink mounting structure example applicable for the multi-chip module according to the fourth embodiment of the present invention, and
Fig. 7 is a vertical cross sectional view showing a heat sink mounting structure example applicable for the multi-chip module according to the fifth embodiment of the present invention.

### Description of the Preferred Embodiment

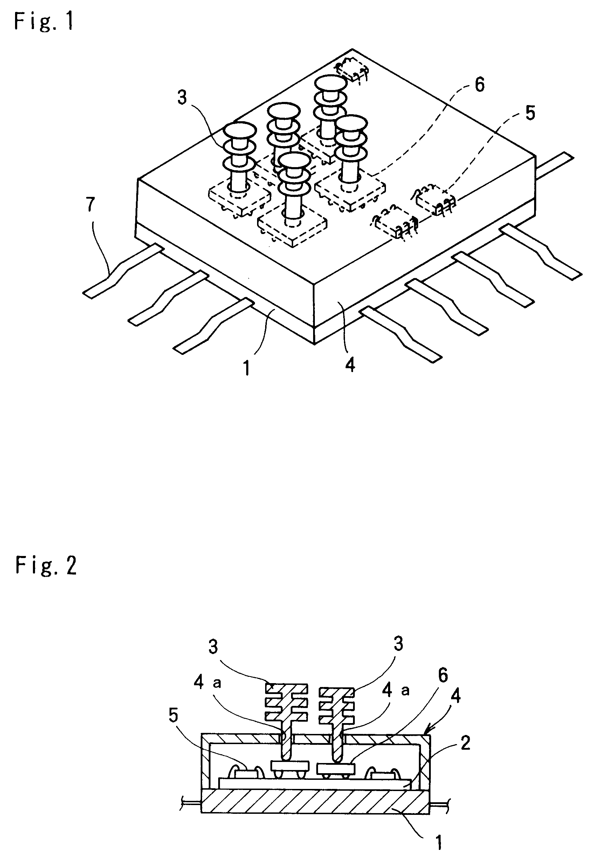

First, the fundamental structure of the semiconductor chip module according to the present invention will be explained referring to Figs. 1 and 2.

A multi-chip module according to the present embodiment includes a lower substrate 1, an upper substrate 2, a heat sink, and a cap 4. The lower substrate 1 is made of an aluminum oxide material, and has plural lead pins 7 extending from the side surfaces thereof, and being connected to electric circuits formed with the upper substrate 2. The upper substrate 2 is made of an insulating material of low dielectric constant. For example, a polyimide multi-layered wiring structure having 3 inches square size, a thermal resistance of 3°C/W with a thermal via may be used(refer to "Copper Polyimide Multi-layered Wiring Boards", HYBRIDS, Vol. 7, No. 1, pp. 10-12).

The lower substrate 1 is formed of a flat plate larger than the upper substrate 1, and fixed securely with the upper substrate 2 piled on top of the upper surface thereof. The upper surface of the lower substrate 1 on which the upper substrate 2 is not piled is covered by the fringe of the cap 4. Therefore, the substrate 2 is enclosed with the cap 4 and the lower substrate 1.

The upper substrate 2 has electrodes exposed on the surface thereof and semiconductor chips 5 and 6 connected to the electrodes is mounted thereon. The semiconductor chips 5 and 6 are made of, for example, an IC chip of 10 mm square, and are connected to the electrodes formed on the surface of the upper substrate 2 by using a wire bonding method or a face-down bonding method (flip chip bonding method, face-down TAB and so on). Referring to Figs. 1 and 2, the semiconductor chip 5 indicates an IC chip mounted using a wire bonding method and the semiconductor chip 6 indicates an IC chip mounted by a face-down bonding method. Therefore, the circuit side of the semiconductor chip 5 faces the cap 4, and the circuit side of the semiconductor chip 6 faces the upper substrate 2.

The cap 4, for example, is formed of in the shape of a lid of 1 mm thick Kovar. An opening 4a of an inner diameter of 6 to 8 millimeter is formed in the cap 4 at the position corresponding to the mounting position of the semiconductor chip 6 which produces a relatively large amount of heat. One end of the heat sink 3 is inserted into the opening 4a.

In this case, for the material of the cap 4 can be used a metal such as aluminum or copper tungsten alloy, and a ceramics such as AlN or SiC.

The heat sink 3 is made of a material of high heat conductivity such as Al, CuW, AlN, CBN, and diamond etc., and includes an insertion portion and a heat dissipation portion. The insertion portion has a shape which allows to be easily inserted into the above mentioned opening 4a for example, a rod shape. Since the heat dissipation portion is exposed to the outside of the cap 4, it has a large surface area to get easily cooled by natural cooling, for example, formed in a disc shape. Therefore, the insertion of the heat sink into the interior of the cap 4 is simple and the contact to the upper surface of the semiconductor chip 6 is easy whereby the heat generated from the semiconductor chip 6 can be effectively dissipated to the outside of the cap 4. Because it is desirable that a contact of the heat sink 3 to the semiconductor chip 6 is a surface contact, where the upper surface of the semiconductor chip 6 is flat, the end portion of the heat sink 3 is preferred to be a flat surface instead of a curved surface.

The outer diameter of the heat sink depends basically on the heat generating area within a semiconductor chip module. For example, in the case where a 10 x 10 mm IC chip is used, and the heat generating area is ranged over the entire upper surface thereof, it is desirable to use a 10 mm diameter heat sink. However, in the case where the heat generating area is a part of a semiconductor chip module, the size of the heat sink has the same as the part thereof. When the heat sink is made of metal, the opening thereof is formed to a diameter larger than the outer diameter of the heat sink by 0.05 mm. When the heat sink is made of ceramic, the opening thereof is formed a diameter larger than the outer diameter of the heat sink by 0.1 mm.

According to the multi-chip module of the present embodiment, the packaging process is carried out, for example, through step (1) of mounting enclosing with a cap 4 the upper surface of an upper substrate 2 having semiconductor chips 5 and 6 mounted thereon and securely fixed to a lower substrate 1; step (2) of inserting one end of a heat sink 3 into an opening 4a of the cap 4 to contact the end thereof to the upper surface of the semiconductor chip 6; and step (3) of fixing securely the heat sink 3 to the cap 4 by embedding a solder material for example into the gap between the opening 4a of the cap 4 and the heat sink 3, under the condition of the heat sink 3 being in contact with the semiconductor chip 6.

As mentioned above, by the multi-chip module according to the present embodiment, a heat sink can be easily mounted only to the semiconductor chip requiring heat dissipation (producing a large amount of heat), heat dissipation of a multi-chip module can be performed selectively and effectively.

In this case, since a single heat sink is mounted with respect to a single semiconductor chip, the heat sink can be mounted reliably to plural semiconductor chips having different heights from the substrate surface.

Furthermore, since heat sink is possible to be mounted to individual semiconductor chip individually, the present invention can be applied for a multi-chip module which includes semiconductor chips mounted by the face-down bonding together with semiconductor chip mounted using wire bonding method, enhancing the utility of the present invention.

As the present invention has the above described structure, it can be applied to multi-chip modules and single-chip modules. The present invention also can provide a high speed semiconductor chip module which has a small number of components and possible to be designed with excellent thermal dissipation design.

If GaAs semiconductor chips and Si semiconductor chips are mounted on the upper substrate, the material of heat sink which has most appropriate coefficient of thermal expansion for each type of semiconductor chips can be used and any material according to the amount of heat produced by semiconductor chip can be selected to increase the efficiency in heat dissipation of the semiconductor chip module.

Furthermore, the multi-chip module embodying the present invention can tolerate variations in height in the face-down bonding process.

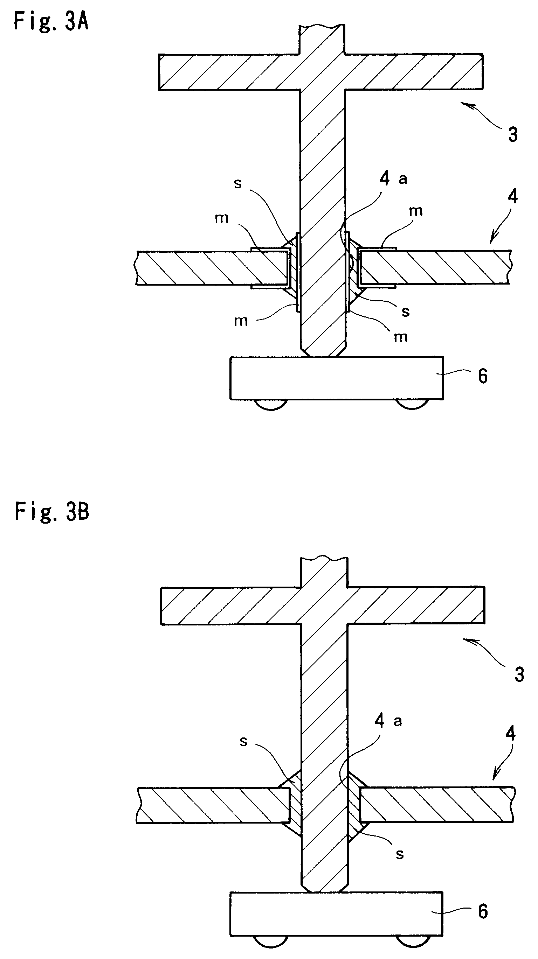

Next, referring to Figs. 3A and 3B, a semiconductor chip module according to one embodiment of the present invention will now be explained. According to the present embodiment, a solder "s" is filled between the heat sink 3 and the cap 4 to fix the heat sink to the cap 4. The heat sink mounting structure of Fig. 3A is different from that of Fig. 3B in that a metal "m" is coated on the surface on which solder "s" is to be applied.

Fig. 3A shows a mounting structure where a metal coating is applied to the periphery of the opening of the cap by plating method. Materials which have a wettable property is used for the metal "m" to be coated on the heat sink 3 and the cap 4 positioned around the opening. As a result, solder welding can be performed without any void and the cap 4 can be sufficiently hermetically sealed. For example, Sb/Pb solder can be employed when a metal such as AgSn or AgPd is used. Generally, the solder "s" is locally heated and welded by means of a blast of hot wind blow or laser. However, when using a low temperature solder added with Bi, Cd, and In, an entire heating process may be performed.

In order to coat a metal on the periphery of the opening of the cap, a mask is placed on the region on which need not a coating for the cap 4. Then, the structure is soaked into a plating liquid to form selectively a metal film. In this case, a metal film is formed to a thickness of 5 to 7 µm by employing an electroless plating method.

In case where both the heat sink 3 and the cap 4 have sufficiently wettable property, the above mentioned metal coating process is unnecessary (refer to Fig. 3B). In this case, the solder "s" is filled between the heat sink 3 and the cap 4 to fix the heat sink 3 to the cap 4.

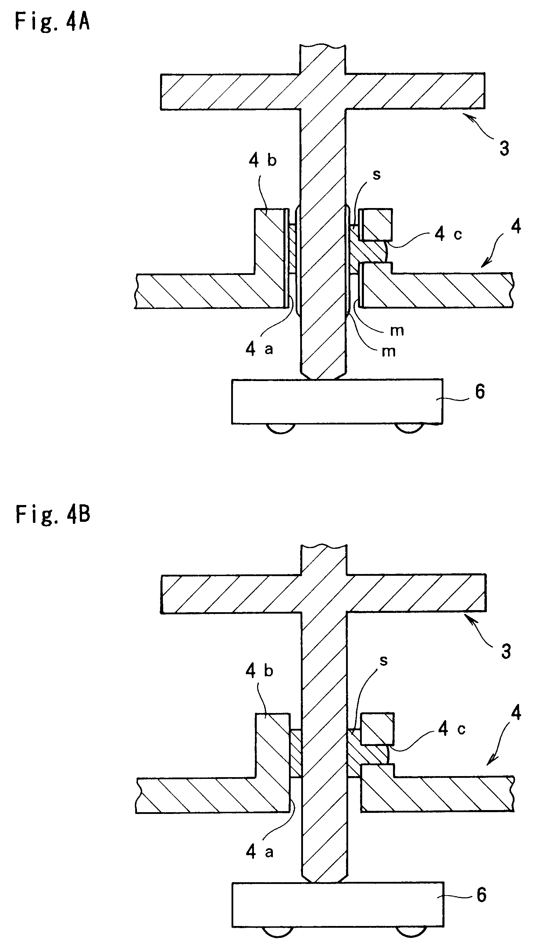

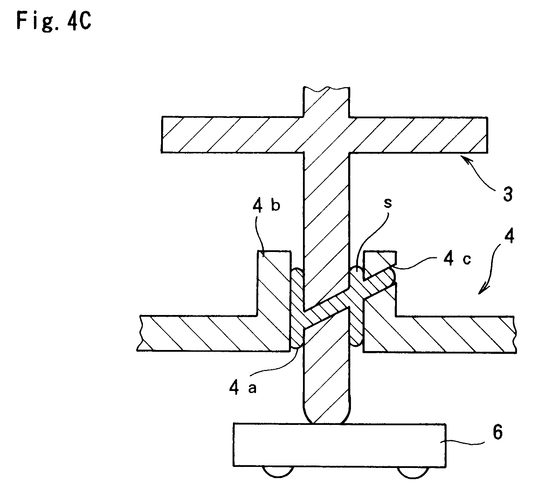

Next, referring to Figs. 4A, 4B and 4C, the semiconductor chip module according to the second embodiment of the present invention will now be explained. In the present embodiment, the cap 4 has a side wall in which an injection hole for solder is formed. The solder "s" is filled between the side wall and a heat sink. The heat sink mounting structure shown in Fig. 4A is different from that in Fig. 4B in that a metal "m" is coated on the surface applying the solder "s". On the other hand, the heat sink mounting structure shown in Fig. 4C is different from that in Fig. 4B in that the heat sink 3 has a through hole and an injection hole 4c formed slantingly.

The side wall 4b also has an injection hole 4c of for example, 0.5 mm diameter communicating with the opening 4a of the cap 4. Solder "s" in the form of liquid is injected from the injection hole 4c and is filled into the gap between the inner wall of the opening 4a and the side wall 4b, and the heat sink 3. In this case, with one end of the heat sink 3 contacting to the semiconductor chip 6, the solder "s" can be injected easily into the opening 4a by rotating the cap 4 about 90 degrees to make the injection hole face upward, then pouring solder "s" from above. The heat sink 3 is fixed on the cap 4 by the solidified solder, with one end thereof contacting the semiconductor chip 6. Since the above mentioned material and heating process can be used for the solder "s", further explanation will be omitted. Furthermore, in order to coat easily the solder "s", a metal "m" is formed on the surface of the heat sink 3 and the inner surface of the side wall 4b on which the solder "s" is contacted (Fig. 4A). Such metal coating with respect to a specific area can be realized by forming a mask the remaining area, except the area to which the solder"s" contacts.

In case where sufficient wettable property is obtained between the heat sink 3 and the cap 4, it is unnecessary to perform a metal coating (Fig. 4B). In this case, the solder "s" goes round the heat sink 3 by filling directly the solder "s" into the injection hole 4c of the cap 4, thus fixing the cap 4.

As mentioned above, the multi-chip module according to the present embodiment is mounted with a heat sink only to the semiconductor chip requiring heat dissipation (producing a large amount of heat), so that the heat dissipation of the multi-chip module can be performed selectively and effectively.

In this case, since a single heat sink is mounted to a single semiconductor chip and one end of the heat sink can be adjusted in length wise in the inserted direction, even when plural semiconductor chips each having different height with respect to the substrate surface are mounted on the substrate, the heat sink can be reliably mounted on individual semiconductor chip.

Furthermore, since heat sinks are mounted individually to individual semiconductor chips, the present invention can be applied to a multi-chip module which includes semiconductor chips mounted by the face-down bonding method together with semiconductor chips mounted by the wire bonding method enhancing its utility.

The injection hole 4c may be either circular, polygonal, or oval and the injection hole 4c may be formed slantingly with respect to the heat sink 3(Refer to Fig.4C). For example, when the injection hole 4c which is formed to tilt by 45 degrees with respect to the heat sink 3, it can look up only by rotating the cap 4 by about 45 degrees. In this case, since the weight of the heat sink 3 itself remains partially added to the semiconductor chip 6, a state where one end of the heat sink 3 is in contact with the semiconductor chip 6 can be easily maintained.

Also, a through hole may be formed at one end of the heat sink 3 positioned near the injection hole 4c(Refer to Fig.4C). Since the solder "s" reaches the inner wall of the opening at the opposite side by way of the through hole, good intrusion of the solder "s" can be achieved.

Next, explanation will be made regarding the method of manufacturing a multi-chip module, according to the present embodiment. The multi-chip module is packaged, after preparing a substrate 2 packaged with semiconductor chip 6, a cap 4 wherein a metal "m" is coated previously on the inner wall of the opening 4a, and a heat sink 3 wherein a metal "m" is coated previously on one end; for example, by way of the steps of: (1) enclosing the upper surface of the upper substrate 2 fixed on the lower substrate 1 with the cap 4, (2) inserting one end of the heat sink 3 into the opening 4a of the cap 4 and then contacting the end portion of the heat sink 3 to the upper surface of the semiconductor chip 6; and (3) fixing the heat sink 3 on the cap 4 by injecting the solder into either the gap between the inner wall of the opening 4a of the cap 4 and the heat sink 3, or the injection hole 4c of the side wall 4b, while maintaining a state of the heat sink 3 being in contact with the semiconductor chip 6, to fix the heat sink 3 to the cap 4, whereby the cap 4 is sealed hermetically.

In this case, when the solder is injected, fixing the cap 4 to the heat sink 3 is simple, since one end of the heat sink 3 is automatically in contact to the semiconductor chip 6 due to its own weight.

Since the solder is filled sufficiently into the gap between the heat sink 3 and the inner wall of the cap 4a, the cap 4 can be sealed hermetically. In particular, when the thin film multi-layered substrate 2 such as polyimide/Cu is used as the upper substrate, the hermetical sealing becomes more important because of the moisture absorption property of polyimide itself. In this case, since the solder has high heat conduction ratio, it is possible to function the cap itself as a heat sink.

The present embodiment having the above described structure, can be applied to multi-chip modules and single-chip module being capable to provide a semiconductor chip module formed of a small number of components, having excellent thermal dissipation design.

Furthermore, the present invention when applied to multi-chip module, can tolerate variations in height of the face-down bonding process, thus improving reliability. The small number of components for the semiconductor chip module enables reducing the number of manufacturing steps as well as the cost of the semiconductor chip module.

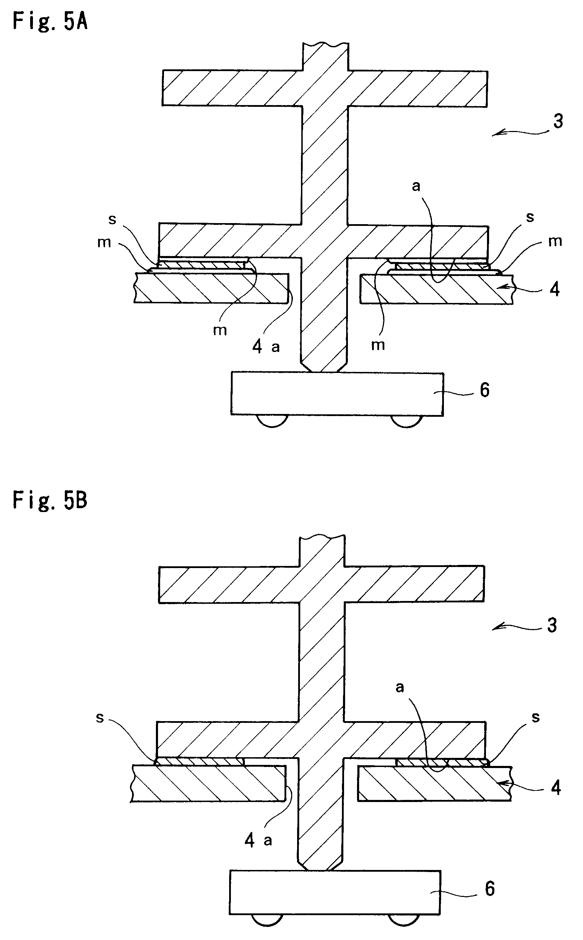

Next, referring to Figs. 5A and 5B, an explanation will now be made as for a semiconductor chip module according to the third embodiment of the present invention. In the present embodiment, by filling the solder "s" between the coating surface "a" of the heat sink 3 and the cap 4, the heat sink 3 is mounted onto the cap 4 while the semiconductor chip module 6 is sealed hermetically. In Fig. 5A, the heat sink mounting structure is different from that shown in Fig. 5B in that a metal "m" is coated on the surface coating the solder "s".

The solder "s" has a thickness of 100 µm and is formed in a ring shape and when the solder "s" is not sandwiched, the gap between the surface "a" and the upper surface of the cap 4 is 10 to 90 µm. The thickness of the solder "s" used is determined considerating the gap between the surface "a" and the upper surface of the cap 4, and the surface tension of the solder. The solder "s" can be one of a Sb/Pb series, and generally is locally heated and welded using thermal wind blow and laser. Also, when a lower temperature solder being added with Bi, Cd, and In is used, heating all over may be carried out. An eutectic alloy preform can be used instead of the solder "s". In this case, in order to improve the wetting, a metal film may be coated on the contact surface. For example, when using a Sb/Pb solder, it is effective to coat a metal of Ag, Sn, AgPd, or the like, and when an eutectic alloy preform such as Au-Si, or Au-Sn (Sn: 20 weight %) is used, it is effective to coat an Am metal film.

In case where a sufficient wettable property is obtained between the heat sink 3 and the cap 4, it is unnecessary to coat a metal (Fig. 5B). In this case, the heat sink can be fixed by placing the solder "s" on the surface "a" of the heat sink 3, whereby the semiconductor chip 6 can be sealed hermetically.

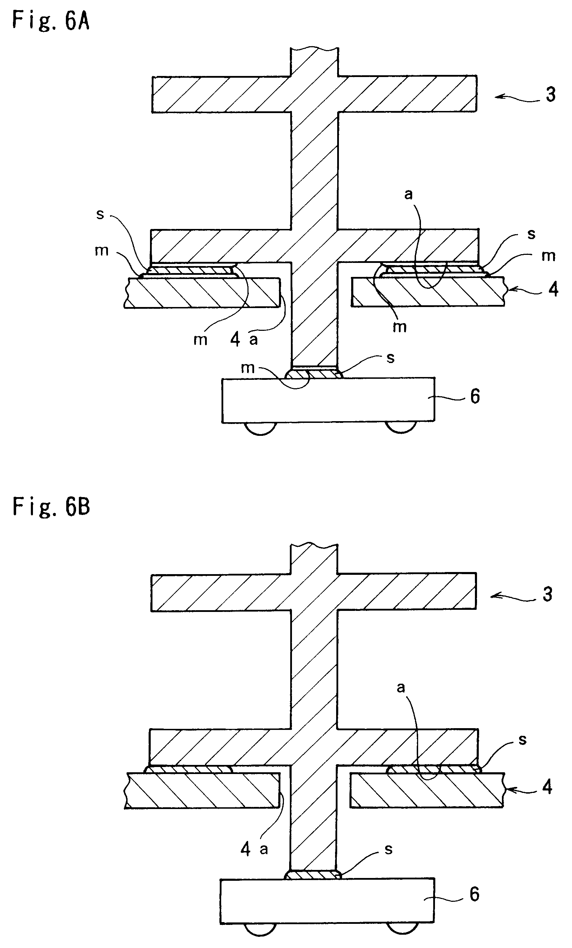

Next, referring to Figs. 6A and 6B, an explanation will now be made regarding a semiconductor chip module according to the fourth embodiment of the present invention.

The present embodiment shows another mounting structure wherein the solder "s" is interposed between the surface "a" of the heat sink 3 and the upper surface of the cap 4, and also between one end of the heat sink 3 and the semiconductor chip 6. The heat sink mounting structure shown in Fig. 6A differs from that in Fig. 6B in that a metal "m" is coated on a surface to be applied with the solder "s". The difference between this mounting structure and the above mentioned mounting structure is in that the solder "s" of about 10 µm thick is interposed between one end of the heat sink 3 and the semiconductor chip 6 and the contact surface between the heat sink 3 and the semiconductor chip 6 is nearly a surface contact. Therefore, the heat generated from the semiconductor chip 6 is effectively conducted the heat sink 3. The thickness of the solder "s" is determined considerating the gap between the surface "a" and the upper surface of the cap 4, the thermal resistance of the solder "s", or the like. Since the above-mentioned materials, heating processes, and metal films can be applied for the solder, an explanation regarding them is omitted. When Sn is used as the solder, the welding becomes further easier by coating an Au film on the upper surface of the semiconductor chip 6.

Next, explanation will be made regarding the method of manufacturing a multi-chip module, according to the third and forth embodiment. The multi-chip module having the mounting structure according to the third embodiment is packaged, after preparing the substrate 2 mounting semiconductor chips 5 and 6, the cap 4, and the heat sink 3; for example, by way of the steps of:
(1) enclosing the upper surface of the upper substrate 2 fixed on the lower substrate with the cap 4, (2) inserting one end of the heat sink 3 into an opening of the cap 4 and then sandwiching the solder "s" between the surface "a" of the heat sink 3 and the upper surface of the cap 4; and (3) fixing the heat sink 3 on the cap 4 through heating the solder "s", with the heat sink 3 contacted to the semiconductor chip 6, to seal hermetically the cap 4. The solder "s" may be fixed previously on the surface "a" of the heat sink 3 to melt the solder "s" by heating the heat sink 3.

In this case, since the solder "s" is filled closely between the surface "a" of the heat sink 3 and the upper surface of the cap 4, the cap can be completely sealed hermetically. In particular, when the thin film multi-layered substrate such as polyimide/Cu is used as the upper substrate, the hermetical sealing becomes important because of the moisture absorption property of the polyimide. In this case, since both the heat sink 3 and the cap 4 are welded using their flat portions, it is possible to obtain workability, and to improve yield, and reliability.

The multi-chip module having the mounting structure according to the forth embodiment is packaged, for example, through the steps of: (1) enclosing the upper surface of the upper substrate 2 fixed on the lower substrate 1 with the cap 4 after preparing the cap 4 and the heat sink 3 having one end on which the solder "s" is fixed; (2) sandwiching the solder "s" between the adhesive surface "a" of the heat sink 3 and the upper surface of the cap 4 by inserting into the opening 4 one end of the heat sink 3 adhered previously with the solder "s"; and (3) melting the solder "s" by heating the heat sink 3 to fix the heat sink 3 to the cap 4, while the heat sink 3 being contacted to the semiconductor chip 6, whereby the cap 4 is sealed hermetically.

In the manufacturing method, since a material with good heat conduction is used for the heat sink 3, it is possible to fix the heat sink 3 and to seal hermetically the cap 4 only by heating the heat sink partially.

Since the adhesive material works as a cushion, it is possible to neglect the surface finish of the end portion of the heat sink 3.

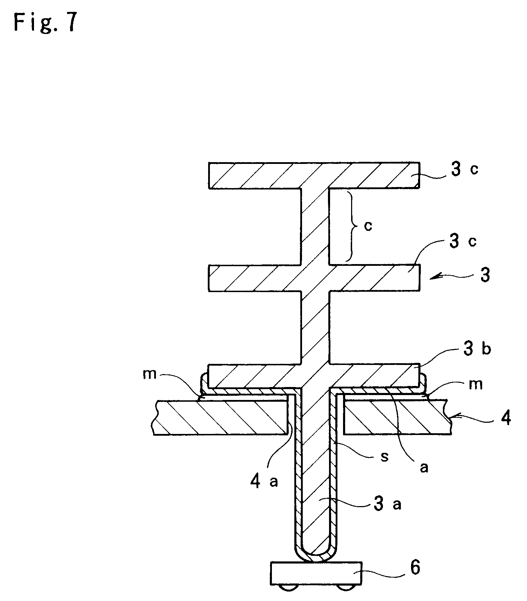

Next, referring to Fig. 7, an explanation will now be made regarding the semiconductor chip module according to the fifth embodiment of the present invention. In the present embodiment, the solder "s" is coated previously on the contact surface "a" and the insertion portion 3a of the heat sink 3. A metal film "m" is coated previously in a ring form near to the opening 4a of the cap 4. The mounting structure is packaged, after preparing the substrate 2 mounting semiconductor chips 5 and 6, the cap 4, and the heat sink 3, for example, through the steps of: (1) enclosing the upper surface of the upper substrate 2 fixed on the lower substrate 1 with the cap 4; (2) inserting one end of the heat sink 3 into the opening of the cap 4 to contact the surface "a" of the heat sink 3 with the metal "m" coated on the upper surface of the cap 4; and (3) fixing the heat sink 3 on the cap 4 by heating the solder "s", with the heat sink 3 contacted with the semiconductor chip 6, whereby the cap 4 is sealed hermetically. In this case, the solder "s" may be heated by heating a heated heat sink 3.

Incidentally, the present invention is not be restricted to the above embodiment. In the present embodiment, a semiconductor chip module which includes a semiconductor chip packaged using wire bonding method and a semiconductor chip packaged using a face-down method and a semiconductor chip mounted with a heat sink thereon has been explained as one example. The present invention also is applicable for a semiconductor chip module mounting a single semiconductor chip and may also include flip chips without heat sink. Furthermore, the opening of the cap may be rectangular or polygonal if it is a shape nearly similar to one end of the heat sink, without being limited to circular form.

The above described embodiment shows the structure that the cap 4 covers the lower substrate 1, but the cap 4 may cover the upper substrate 2.

The present invention having the above described structure, can be applied to multi-chip modules and single-chip modules to provide a semiconductor chip module with good hermetic property and high reliability, constituted of a small number of components and having an excellent thermal dissipation design.

Furthermore, the multi-chip module embodying the present invention can tolerate variations in height caused by the face-down bonding process, which improves reliability. Also the small number of components for a semiconductor chip module enables to reduce the number of manufacturing steps as well as reduction in the cost of the semiconductor chip module.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

## Claims

1. A semiconductor chip module comprising:
a first substrate (1) on which a wiring portion is formed;
a semiconductor chip (6) mounted so as to face a circuit side down to said wiring portion;
a heat sink (3) with one end in contact with the side opposite to the circuit side of said semiconductor chip; and
a cap (4) enclosing said semiconductor chip and having an opening for exposing externally the other end of said heat sink.

2. A semiconductor chip module according to claim 1, further comprising:
a second substrate (2) for covering said semiconductor chip with said cap, said second substrate having a mounting portion on which said first substrate is fixed, and a fixing portion on which a fringe portion of said cap is fixed.

3. In a method of manufacturing a semiconductor chip module according to claim 2, said method of manufacturing, comprising the steps of:
preparing the first substrate mounting said semiconductor chip and fixed on said second substrate, the cap, and the heat sink;
fixing said cap on said second substrate;
inserting one end of said heat sink into the opening of said cap to contact the one end of said heat sink to said semiconductor chip; and
filling an adhesive material between said heat sink and said cap, with said semiconductor chip contacted to the one end of said heat sink, to fix said heat sink to said cap.

4. A semiconductor chip module according to claim 1,
wherein metal films are formed at least on the inner wall of the opening of said cap and a surface of said heat sink facing said inner wall; and an adhesive material is filled between said metal layers.

5. A semiconductor chip module according to claim 4, further comprising:
a second substrate having a mounting portion on which said first substrate is fixed, and a fixing portion on which the fringe of said cap is fixed, and enclosing said semiconductor chip module together with said cap.

6. A method of manufacturing the semiconductor chip module according to claim 5, comprising the steps of:
preparing a first substrate mounting said semiconductor chip and fixed on said second substrate, a cap where a metal film is formed previously on the inner wall of said opening, and a heat sink where a metal film is formed previously on one end thereof;
fixing said cap on said second substrate;
inserting the one end of said heat sink into the opening of said cap to contact the one end of said heat sink to said semiconductor chip; and
filling an adhesive material between said metal films, with said semiconductor chip contacted to the one end of said heat sink, to fix said heat sink to said cap, whereby said cap is sealed hermetically.

7. A semiconductor chip module according to claim 1;
wherein said cap has a side wall for supporting said heat sink, said side wall having an injection hole in communication with said opening, and said adhesive material is filled between said side wall and said heat sink through said injection hole.

8. A semiconductor chip module according to claim 7, further comprising:
a second substrate having a mounting portion on which said first substrate is fixed and a fixing portion on which the fringe portion of said cap is fixed, and enclosing said semiconductor chip module together with said cap.

9. A semiconductor chip module according to claim 7,
wherein a metal film is formed at least on the inner surface of the side wall of said cap; and
wherein a metal film is formed on the surface of said heat sink facing said inner surface of said side wall; and wherein an adhesive material is filled between said metal films.

10. A semiconductor chip module according to claim 7,
wherein a thorough hole is formed at one end of said heat sink located near to said injection hole.

11. A semiconductor chip module according to claim 7,
wherein said injection hole is formed slantingly with respect to the inserting direction of said heat sink.

12. A method of manufacturing a semiconductor chip module according to claim 8, comprising the steps of:
preparing a first substrate mounting said semiconductor chip and fixed on said second substrate, a said cap, and said heat sink;
fixing said cap on said second substrate;
inserting one end of said heat sink into the opening of said cap to contact said one end to said semiconductor chip; and
injecting an adhesive material into said injection hole of said side wall, with said one end of said heat sink contacted to said semiconductor chip, to fix said heat sink to said cap, whereby said cap is sealed hermetically.

13. A semiconductor chip module according to claim 1,
wherein said heat sink has an adhesive surface which is fixed on said cap using an adhesive material; and
wherein an adhesive material is filled into the gap between said cap and said adhesive surface of said heat sink.

14. A semiconductor chip module according to claim 13, further comprising:
a second substrate having a mounting portion an upper surface on which said first substrate is fixed and a fixing portion on which the fringe portion of said cap is fixed, enclosing said semiconductor chip module together with said cap.

15. A semiconductor chip module according to claim 13,
wherein metal films are formed at least on the adhesive surface of said heat sink and on the surface of said cap facing said surface of said heat sink; and
wherein an adhesive material is filled said metal films.

16. A method of manufacturing the semiconductor chip module according to claim 14, comprising the steps of:
preparing a first substrate mounting said semiconductor chip and fixed on said second substrate, said cap, and said heat sink;
fixing said cap on said second substrate;
inserting one end of said heat sink into the opening of said cap to sandwich a thermosetting adhesive material between said cap and said the surface of said heat sink; and
fixing said heat sink to said cap by heating said thermosetting adhesive material, with said one end of said heat sink contacted to said semiconductor chip, whereby said cap is sealed hermetically.

17. A semiconductor chip module according to claim 13,
wherein said thermosetting adhesive material is filled between the one end of said heat sink and said semiconductor chip.

18. A semiconductor chip module according to claim 17, further comprising:
a second substrate having an mounting portion on which said first substrate is fixed and a fixing portion on which said cap is fixed, and wherein said semiconductor module is enclosed together with said cap.

19. A semiconductor chip module according to claim 17,
wherein metal films are formed at least on the surface of said heat sink and on the surface of said cap facing said surface of said heat sink; and
wherein an adhesive material is filled between said metal films; and wherein a metal film is formed on the one end of said heat sink and a thermosetting adhesive material is filled between said metal film and said semiconductor chip.

20. A method of manufacturing a semiconductor chip module according to claim 18, comprising the steps of:
preparing a first substrate mounting said semiconductor chip and fixed on said second substrate, said cap, and said heat sink which has one end coated with a thermosetting adhesive material;
fixing said cap on said second substrate mounting said semiconductor chip;
inserting the one end of said heat sink into the opening of said cap to sandwich said thermosetting adhesive material between said cap and the surface of said heat sink; and
fixing said heat sink to said cap by heating said thermosetting adhesive material, with said one end of said heat sink contacted to said semiconductor chip, whereby said cap is sealed hermetically.
